# DEMANDE DE BREVET EUROPEEN

(11) **EP 2 685 501 A1**
(43) Date de publication de la demande: **15.01.2014**
(21) Numéro de dépôt: 13175436.8
(22) Date de dépôt: 05.07.2013
(51) Int. Cl.: H01L 27/12, H01L 27/02, H01L 27/06, H01L 29/786

(54) **Circuit integre sur soi comprenant un transistor de protection sous-jacent**

(30) Priorité: 13.07.2012 FR 1256804
(71) Demandeur: Commissariat à l'Énergie Atomique et aux Énergies Alternatives, 75015 Paris (FR); STmicroelectronics SA, 92120 Montrouge (FR)
(72) Inventeur: Fenouillet-Beranger, Claire, 38000 GRENOBLE (FR); Fonteneau, Pascal, 38570 THEYS (FR)
(74) Mandataire: Guérin, Jean-Philippe

(57) **Abrégé**

L'invention concerne un circuit intégré (9), comprenant :
-un premier transistor à effet de champ (1) ;
-une couche isolante enterrée (92) de type UTBOX ;
-un plan de masse (11) à l'aplomb de la grille et du canal du premier transistor (92) ;
-un premier élément semiconducteur (13) ;
-un deuxième élément semiconducteur (19) décalé latéralement par rapport à la grille du premier transistor ;
-des première et deuxième électrodes (18, 14) en contact avec le plan de masse (11) et avec le premier élément semi-conducteur (13);
-un caisson semi-conducteur (12) à l'aplomb du premier plan de masse et des premier et deuxième éléments semi-conducteurs;
-une première tranchée d'isolation (65) isolant le premier transistor (1);
-des deuxième et troisième tranchées d'isolation (62,63) isolant le premier transistor (1) et s'étendant jusqu'à une profondeur strictement inférieure à l'interface entre le plan de masse et le caisson.

## Description

L'invention concerne les circuits intégrés, et en particulier les circuits intégrés réalisés sur un substrat de type silicium sur isolant (SOI). La technologie SOI consiste à séparer une fine couche de silicium (quelques nanomètres) sur un substrat en silicium par une couche d'isolant relativement épaisse (quelques dizaines de nanomètres en règle générale).

Les circuits intégrés réalisés en technologie SOI présentent un certain nombre d'avantages. De tels circuits présentent généralement une plus faible consommation électrique pour des performances équivalentes. De tels circuits induisent également des capacités parasites plus faibles, qui permettent d'améliorer la vitesse de commutation. De plus, le phénomène de déclenchement parasite (« latchup » en langue anglaise) rencontré par les transistors MOS en technologie Bulk peut être évité. De tels circuits s'avèrent donc particulièrement adaptés pour des applications de type SoC ou MEMS. On constate également que les circuits intégrés SOI sont moins sensibles aux effets des radiations ionisantes et s'avèrent ainsi plus fiables dans des applications où de telles radiations peuvent induire des problèmes de fonctionnement, notamment dans des applications spatiales. Les circuits intégrés SOI peuvent notamment comprendre des mémoires vives de type SRAM ou des portes logiques.

La réduction de la consommation statique de portes logiques tout en augmentant leur vitesse de basculement fait l'objet de nombreuses recherches. Certains circuits intégrés en cours de développement intègrent à la fois des portes logiques à faible consommation et des portes logiques à vitesse de basculement élevée. Pour générer ces deux types de portes logiques sur un même circuit intégré, on rabaisse la tension de seuil de certains transistors des portes logiques à accès rapide, et on augmente la tension seuil d'autres transistors des portes logiques à faible consommation. En technologie Bulk, la modulation du niveau de tension de seuil de transistors de même type est effectuée en différenciant le niveau de dopage de leur canal. Cependant, en technologie FDSOI (pour « Fully Depleted Silicium On Insulator » en langue anglaise, désignant du silicium totalement déserté sur isolant), le dopage du canal est quasiment nul (10¹⁵ cm⁻³). Ainsi, le niveau de dopage du canal des transistors ne peut donc pas présenter de variations importantes, ce qui empêche de différencier les tensions de seuil par ce biais. Une solution proposée dans certaines études pour réaliser des transistors de même type à tensions de seuil distinctes est d'intégrer différents matériaux de grille pour ces transistors. Cependant, la réalisation pratique d'un tel circuit intégré s'avère techniquement délicate et économiquement prohibitive.

Afin de disposer de tensions de seuil distinctes pour différents transistors en technologie FDSOI, il est également connu d'utiliser un plan de masse polarisé disposé entre une couche d'oxyde isolante mince et le substrat de silicium. En jouant sur le dopage des plans de masse et sur leur polarisation, on peut définir une gamme de tensions de seuil pour les différents transistors. On pourra ainsi disposer de transistors à faible tension de seuil dits LVT, de transistors à haute tension de seuil dits HVT et de transistors à tension de seuil moyenne dits SVT.

Pour permettre le fonctionnement des différents transistors, il est nécessaire de les isoler électriquement les uns des autres. Par conséquent, les transistors sont généralement entourés par des tranchées d'isolation (désignées par l'acronyme STI pour « Shallow Trench Isolation » en langue anglaise) qui s'étendent jusqu'aux caissons.

De façon connue, de tels circuits intégrés incluent également des dispositifs de protection contre des décharges électrostatiques (ESD, pour « Electrostatic Discharge » en langue anglaise) accidentelles et pouvant détériorer ces transistors.

Le document US2012/056273 décrit un circuit intégré comprenant un transistor à effet de champ disposé sur une couche isolante enterrée. Un plan de masse est disposé à l'aplomb de la grille et du canal du transistor, sous la couche isolante enterrée.

Il existe un besoin pour des dispositifs de protection contre les décharges électrostatiques n'affectant que marginalement la densité d'intégration, permettant de dériver un important courant de décharge, et permettant potentiellement d'assurer une protection locale du circuit intégré. L'invention porte ainsi sur un circuit intégré tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :
- la figure 1 est une vue de dessus schématique d'une portion de circuit intégré selon un premier mode de réalisation de l'invention ;
- la figure 2 illustre une vue en coupe transversale du circuit intégré de la figure 1 ;
- la figure 3 illustre une vue en coupe transversale d'un cas particulier du circuit intégré de la figure 1 ;
- la figure 4 est un schéma électrique d'un exemple d'application du circuit intégré de la figure 3 ;
- la figure 5 est un schéma électrique d'un exemple d'application d'une variante du circuit intégré de la figure 3 ;
- la figure 6 illustre une vue en coupe transversale d'un autre mode de réalisation d'un circuit intégré ;
- la figure 7 illustre une vue en coupe transversale d'une variante du circuit intégré de la figure 1.

L'invention propose d'utiliser, dans un circuit intégré, des tranchées d'isolation de profondeur et de dimensions réduites afin de réaliser un dispositif de protection ESD du circuit intégré. Un tel dispositif de protection est formé d'un transistor, ménagé sous un composant électronique. Ce dispositif de protection ne nuit donc pas à la densité d'intégration du circuit et permet d'assurer une protection contre les décharges électrostatiques en dérivant un important courant de décharge.

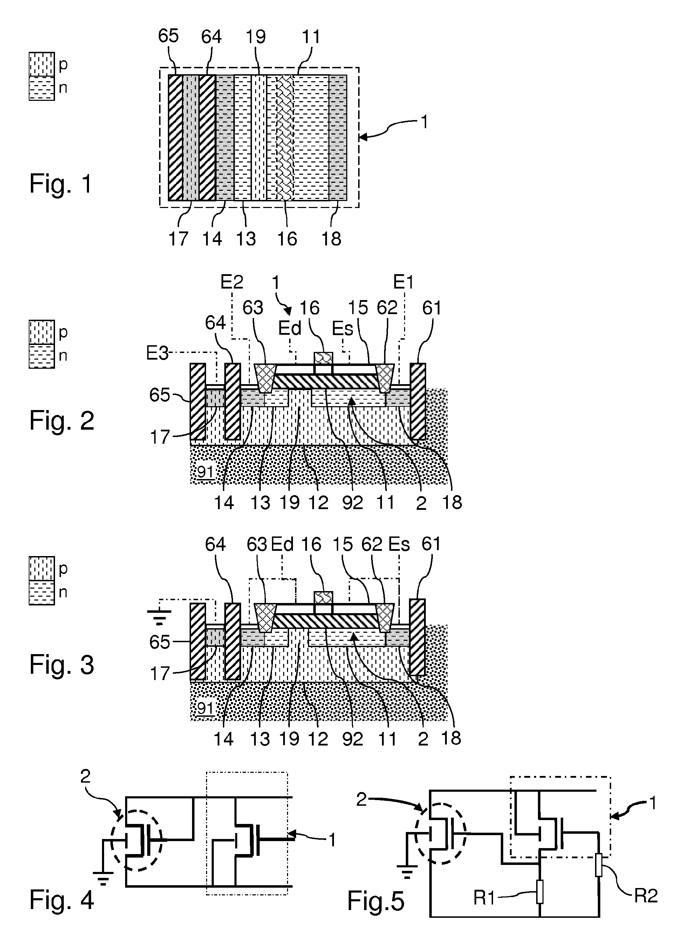

La figure 1 est une vue de dessus schématique d'une portion d'un circuit intégré fabriqué sur SOI, en coupe au niveau de plans de masse et de zones implantées. Le circuit intégré comporte ici un transistor à effet de champ 1. La figure 2 est une vue en coupe transversale du circuit intégré. Le transistor 1 est réalisé dans une couche d'un matériau semi-conducteur, dite couche active, formée sur une couche isolante 92, cette couche isolante 92 étant formée à l'aplomb d'un substrat semi-conducteur 91, typiquement à dopage de type p.

Le transistor 1 est par exemple un transistor nMOS. Le transistor nMOS est généralement aligné avec d'autres transistors nMOS dans une rangée de cellules, chaque cellule incluant un transistor nMOS et un transistor pMOS.

Le transistor 1 comporte de façon connue en soi une source, un drain et un canal, et un empilement de grille réalisé à l'aplomb du canal. La source, le drain et le canal du transistor 1 sont ménagés dans la couche active semi-conductrice 15. Le transistor 1 comporte un empilement de grille 16 disposé sur la couche active semi-conductrice 15, à l'aplomb de son canal. Le transistor de la couche active peut de façon connue en soi être de type FDSOI (pour « Fully Depleted Silicon On Insulator » en langue anglaise) avec un canal en matériau semi-conducteur faiblement dopé, le canal ayant une concentration de dopants sensiblement égale à la concentration de dopants du substrat 91. Le transistor 1 comporte également des électrodes de source et de drain, non illustrées, sur lesquelles sont appliqués respectivement les potentiels Es et Ed.

Un plan de masse 11 semi-conducteur est formé à l'aplomb du transistor 1, sous la couche isolante enterrée 92. Le dopage du plan de masse 11 est de type n. Le plan de masse 11 s'étend sous la majeure partie de la couche isolante enterrée. Le plan de masse 11 s'étend à l'aplomb de l'empilement de grille 16 et du canal du transistor 1.

Le plan de masse 11 est polarisé par une zone implantée 18 semi-conductrice, à un potentiel E1. La zone implantée 18 présente un dopage de type n (et de préférence un dopage N+). La polarisation du plan de masse 11 peut être effectuée par l'intermédiaire d'un circuit de polarisation non représenté ici.

Une tranchée d'isolation 62 est ménagée à l'aplomb du contact entre le plan de masse 11 et la zone implantée 18. La tranchée d'isolation 62 traverse ici la couche isolante 92 et s'étend donc jusqu'au plan de masse 11. La tranchée 62 n'atteint pas le fond du plan de masse 11 ou de la zone implantée 18, afin de préserver un contact entre eux. La tranchée d'isolation 62 permet d'améliorer l'isolation entre le transistor 1 et la zone implantée 18.

Des tranchées d'isolation 61 et 65 sont par ailleurs ménagées en périphérie, afin d'isoler le transistor 1, par rapport aux éléments sous-jacents qui vont être détaillés, et par rapport aux électrodes de ces éléments. La tranchée d'isolation 61 est ménagée au niveau d'une bordure de la zone implantée 18. La tranchée 61 s'étende à travers la couche isolante enterrée 92 jusqu'au caisson 12, sans atteindre le substrat 91. La tranchée 61 peut présenter la même profondeur que la tranchée 62 pour former une diode de protection latérale. 18.

Une zone semi-conductrice 13 est formée à l'aplomb du transistor 1, sous la couche isolante enterrée 92. Le dopage de la zone 13 et de type n. La zone 13 est placée à l'aplomb du drain du transistor 1, au niveau d'une bordure de ce transistor. La zone 13 est décalée latéralement par rapport à l'empilement de grille 16.

La zone 13 est polarisée par une zone implantée 14 semi-conductrice, à un potentiel E2. La zone implantée 14 présente un dopage de type n (et de préférence un dopage N+). La polarisation de la zone 13 peut être effectuée par l'intermédiaire du circuit de polarisation mentionné précédemment.

Une tranchée d'isolation 63 est ménagée à l'aplomb du contact entre la zone 13 et la zone implantée 14. La tranchée d'isolation 63 traverse ici la couche isolante 92 et s'étend donc jusqu'à la zone 13. La tranchée d'isolation 63 présente avantageusement la même profondeur que la tranchée d'isolation 62. La tranchée 63 n'atteint pas le fond de la zone 13 ou de la zone implantée 14, afin de préserver un contact entre eux. La tranchée d'isolation 63 permet d'améliorer l'isolation entre le transistor 1 et la zone implantée 14.

Un caisson 12 semi-conducteur est formé à l'aplomb du plan de masse 11 et de la zone 13. Le dopage du caisson 12 est de type p. Le caisson 12 s'étend latéralement à l'aplomb des zones implantées 14 et 18. Le caisson 12 comporte en outre une portion 19 s'étendant verticalement vers le haut et séparant la zone 13 du plan de masse 11. La portion 19 forme un canal inférieur entre la zone 13 et le plan de masse 11. Le canal inférieur 19 est décalé latéralement par rapport à l'empilement de grille 16, et disposé à l'aplomb d'une électrode du transistor 1 (en l'occurrence le drain). La zone 19 peut présenter une largeur de 0,2µm, et est avantageusement comprise entre 0,1 et 0,3µm. La zone 19 peut présenter une épaisseur équivalente à l'épaisseur du plan de masse 11.

Les fonds des zones implantées 14 et 18 sont en contact avec le caisson 12. La zone implantée 18 permet à la fois de polariser le plan de masse 11, et de former une électrode pour un dispositif de protection contre les décharges électrostatiques entre deux potentiels. La zone implantée 14 forme une autre électrode pour ce dispositif de protection.

Le caisson 12 est polarisé par une zone implantée 17 semi-conductrice, à un potentiel E3. La zone implantée 17 présente un dopage de type p (et de préférence de dopage P+). La polarisation du caisson 12 peut être effectuée par l'intermédiaire du circuit de polarisation mentionné précédemment. Le fond de la zone implantée 17 est en contact avec le caisson 12.

La zone implantée 17 est ménagée entre la tranchée d'isolation 65 et une tranchée d'isolation 64. Les tranchées d'isolation 64 et 65 s'étendent à travers la couche isolante enterrée 92 jusqu'au caisson 12, sans atteindre le substrat 91. Le caisson 12 s'étend ainsi latéralement jusqu'à l'aplomb de la zone implantée 17, sous les tranchées d'isolation 62, 63 et 64. Les tranchées d'isolation 64 et 65 présentent avantageusement une même profondeur.

Les zone implantées 14, 17 et 18 sont coplanaires au plan de masse 11, au canal inférieur 19, et à la zone 13. Par coplanaire, on entend que l'on peut définir un plan parallèle à la couche 92 et traversant les zones concernées.

La couche isolante enterrée 92, de façon connue en soi, isole électriquement le transistor 1 de son plan de masse 11, de son caisson 12, et du substrat 91. Le substrat 91 peut par exemple être polarisé à une tension de masse Gnd.

La couche isolante enterrée 92 formée à l'aplomb du transistor est ici de type UTBOX (« Ultra-Thin Buried Oxide Layer » en langue anglaise). Ainsi, le contrôle de la polarisation du plan de masse 11 (aussi appelé grille arrière, ou 'back gate' en langue anglaise) permet de moduler la tension de seuil du transistor 1. Le plan de masse 11 s'étendant sous le canal du transistor 1, sa polarisation permet d'influencer la tension de seuil de ce transistor. La couche isolante 92 présente par exemple une épaisseur inférieure ou égale à 60nm, inférieure ou égale à 50nm, voir inférieure ou égale à 20nm. La couche isolante 92 peut être réalisée de façon connue en soi en oxyde de silicium.

Un transistor à effet de champ 2 sous-jacent de type nMOS est ainsi formé sous le transistor 1. Le drain de ce transistor 2 est ici formé par l'association de la zone implantée 14 et de la zone 13, et sa source est formée par l'association de la zone implantée 18 et du plan de masse 11. Le canal inférieur 19 forme le canal de ce transistor 2. La couche isolante enterrée 92 est ici utilisée comme isolant de grille. Une électrode du transistor 1, ici le drain, est utilisée comme grille pour ce transistor 2. Par une polarisation appropriée du drain du transistor 1, le champ électrique généré sur le canal inférieur 19 permet de rendre celui-ci passant. Ainsi, en présence d'une décharge électrostatique, le transistor 2 peut être rendu passant pour assurer une décharge entre les potentiels E1 et E2 (correspondant par exemple à des potentiels définis par des rails d'alimentation du circuit intégré) à travers le caisson 12, et ainsi protéger des composants connectés entre ces potentiels.

La profondeur des tranchées 62 et 63 permet d'ajuster les résistances d'accès de drain et source du transistor 2. La profondeur des tranchées 62 et 63 permet donc aussi d'ajuster la résistance de ballast en cas de déclenchement du phénomène de « snapback », permettant une uniformisation du courant de décharge.

Le caisson 12 peut présenter des concentrations de dopants comprises entre 10¹⁶cm⁻³ et 10¹⁸cm⁻³. Le plan de masse 11 et la zone 13 peuvent présenter des concentrations de dopants comprises entre 10¹⁸cm⁻³ et 10¹⁹cm⁻³. Le canal inférieur 19 pourra présenter une concentration de dopants identique à celles du plan de masse 11 et de la zone 13 ou du caisson 12. Le caisson 12 peut s'étendre jusqu'à une profondeur inférieure à 1µm et, de préférence, inférieure ou égale à 700nm.

Des contacts métalliques peuvent être déposés après siliciuration directement sur chacun des zones implantées 14, 17 et 18, afin de permettre une connexion électrique de chacun d'eux. Avantageusement, les des zones implantées 14, 17 et 18 présentent chacun une concentration de dopants au moins cinquante fois, ou cent fois supérieure à la concentration de dopants du caisson 12. Par exemple, les des zones implantées 14, 17 et 18 présentent des concentrations de dopants avantageusement supérieures ou égales à 5*10¹⁸cm⁻³ et, de préférence, comprises entre 10¹⁹cm⁻³ et 10²¹cm⁻³. Ces concentrations de dopants sont par exemple sensiblement égales aux concentrations de dopants de la source ou du drain du transistor 1. Les des zones implantées 14, 17 et 18 sont ménagées latéralement par rapport au transistor 1.

La figure 3 est une vue en coupe transversale d'un cas particulier de configuration du circuit intégré des figures 1 et 2. Dans cet exemple, le potentiel de drain Ed est appliqué sur la zone implantée 14, et le potentiel de source Es est appliqué sur la zone implantée 18. Un potentiel de masse Gnd est ici appliqué sur la zone implantée 17 et sur le substrat semi-conducteur 91.

La figure 4 est un schéma électrique d'un exemple d'application du circuit intégré de la figure 3. Le transistor nMOS 1 est ici un composant électronique que l'on souhaite protéger localement contre les décharges électrostatiques. Comme détaillé précédemment, le drain du transistor 1 est utilisé comme grille du transistor 2. Les drains des transistors 1 et 2 sont au potentiel Ed et les sources des transistors 1 et 2 sont au potentiel Es. Le substrat 91 est utilisé comme corps (pour body en langue anglaise) du transistor 2 polarisé au potentiel Gnd. Le caisson 12 peut être aussi isolé du substrat 91 en utilisant une couche profonde d'isolation. Le corps du transistor 2 peut alors être polarisé avec un potentiel différent du substrat 91 qui est mis a la masse.

Lors d'une élévation du potentiel Ed éventuellement induite par une décharge électrostatique, le transistor 2 se ferme pour dériver la décharge électrostatique sous le transistor 1, entre les potentiels Ed et Es. Le transistor 2 assure ainsi une protection locale contre les décharges électrostatiques, permettant de dériver un courant de décharge important avec un temps de déclenchement réduit. Le transistor 2 formé étant pour majeure partie placé sous le transistor 1, il n'induit qu'une baisse de densité d'intégration limitée pour le circuit intégré.

La figure 5 est un schéma électrique d'une autre application pour une variante du circuit intégré de la figure 3. Dans cette variante, le transistor nMOS 1 est destiné à commander le transistor 2 formé, pour assurer une protection centralisée pour d'autres composants du circuit intégré, entre les potentiels Ed et Es.

Le substrat 91 est polarisé au potentiel de masse Gnd. Le plan de masse 11 du transistor 1 est ici ménagé à l'aplomb de son drain, la zone 13 est ménagée à l'aplomb de sa source, la zone 19 est ménagée à l'aplomb de sa source et est décalée latéralement par rapport à l'empilement de grille 16. Ainsi, la source du transistor 1 est utilisée comme grille du transistor 2. Le drain du transistor 1 et la zone implantée 14 sont polarisés au potentiel Ed. La source du transistor 1 et la zone implantée 18 sont polarisés au potentiel Es.

Dans le cas d'un caisson 12 isolé du substrat 91 par un caisson profondément enterré, le corps du transistor 2 peut aussi être connecté à la grille et donc au potentiel Es, en abaissant ainsi la tension de seuil du transistor 2.

Une résistance R1 est formée entre la source du transistor 1 et le potentiel Es. Une résistance R2 est formée entre la grille du transistor 1 et le potentiel Ed. Une décharge électrostatique induisant une élévation du potentiel Es ferme le transistor 1, et provoque la fermeture du transistor 2. Le transistor 1 permet ainsi de commander la fermeture du transistor 2 en présence d'une telle décharge électrostatique.

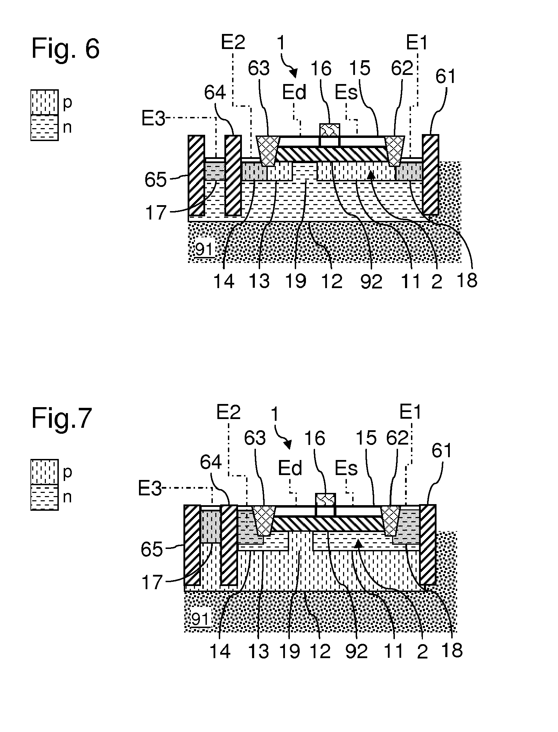

La figure 6 est une vue en coupe transversale d'un autre mode de réalisation d'un circuit intégré. Le transistor à effet de champ 1 est réalisé dans la couche active 15, formée sur la couche isolante 92, formée à l'aplomb du substrat semi-conducteur 91 (à dopage de type p). Le transistor 1 est également du type FDSOI. Le transistor 1 comporte une source, un drain et un canal, et un empilement de grille 16 réalisé à l'aplomb du canal. La source, le drain et le canal du transistor 1 sont ménagés dans la couche active 15. Des potentiels Es et Ed sont appliquées respectivement sur les électrodes de source et de drain du transistor 1.

Le plan de masse 11 semi-conducteur (formé à l'aplomb du transistor 1 sous la couche isolante enterrée 92) présente un dopage de type p. Le plan de masse 11 s'étend sous la majeure partie de la couche isolante enterrée. Le plan de masse 11 s'étend à l'aplomb de l'empilement de grille 16 et du canal du transistor 1.

Le plan de masse 11 est polarisé par la zone implantée 18 semi-conductrice, à un potentiel E1. La zone implantée 18 présente un dopage de type p (et de préférence un dopage P+).

La tranchée d'isolation 62 est ménagée à l'aplomb du contact entre le plan de masse 11 et la zone implantée 18. La tranchée d'isolation 62 traverse ici la couche isolante 92 et s'étend donc jusqu'au plan de masse 11. La tranchée 62 n'atteint pas le fond du plan de masse 11 ou de la zone implantée 18, afin de préserver un contact entre eux.

Les tranchées d'isolation 61 et 65 sont par ailleurs ménagées en périphérie, afin d'isoler le transistor 1, par rapport aux éléments sous-jacents, et par rapport aux électrodes de ces éléments. La tranchée d'isolation 61 est ménagée au niveau d'une bordure de la zone implantée 18. La tranchée 61 présente ici la même profondeur que la tranchée 64, et s'étend donc à travers la couche isolante 62 jusqu'en contact avec la zone implantée 18.

La zone semi-conductrice 13 (formée à l'aplomb du transistor 1, sous la couche isolante enterrée 92) présente un dopage de type p. La zone 13 est placée à l'aplomb du drain du transistor 1, au niveau d'une bordure de ce transistor. La zone 13 est décalée latéralement par rapport à l'empilement de grille 16.

La zone 13 est polarisée par la zone implantée 14 semi-conductrice, à un potentiel E2. La zone implantée 14 présente un dopage de type p (et de préférence un dopage P+).

La tranchée d'isolation 63 est ménagée à l'aplomb du contact entre la zone 13 et la zone implantée 14. La tranchée d'isolation 63 traverse ici la couche isolante 92 et s'étend donc jusqu'à la zone 13. La tranchée d'isolation 63 présente avantageusement la même profondeur que la tranchée d'isolation 62. La tranchée 63 n'atteint pas le fond de la zone 13 ou de la zone implantée 14, afin de préserver un contact entre eux.

Le caisson 12 semi-conducteur est formé à l'aplomb du plan de masse 11 et de la zone 13. Le dopage du caisson 12 est de type n. Le caisson 12 s'étend latéralement à l'aplomb des zones implantées 14 et 18. La portion 19 du caisson 12 s'étend verticalement vers le haut et sépare la zone 13 du plan de masse 11. La portion 19 forme un canal inférieur entre la zone 13 et le plan de masse 11. Le canal inférieur 19 est décalé latéralement par rapport à l'empilement de grille 16, et disposé à l'aplomb d'une électrode du transistor 1 (en l'occurrence le drain).

Les fonds des zones implantées 14 et 18 sont en contact avec le caisson 12. La zone implantée 18 permet à la fois de polariser le plan de masse 11, et de former une électrode pour un dispositif de protection contre les décharges électrostatiques entre deux potentiels. La zone implantée 14 forme une autre électrode pour ce dispositif de protection.

Le caisson 12 est polarisé par la zone implantée 17 semi-conductrice, à un potentiel E3. La zone implantée 17 présente un dopage de type n (et de préférence de dopage N+). Le fond de la zone implantée 17 est en contact avec le caisson 12.

La zone implantée 17 est ménagée entre la tranchée d'isolation 65 et la tranchée d'isolation 64. Les tranchées d'isolation 64 et 65 s'étendent à travers la couche isolante enterrée 92 jusqu'au caisson 12, sans atteindre le substrat 91. Le caisson 12 s'étend ainsi latéralement jusqu'à l'aplomb de la zone implantée 17, sous les tranchées d'isolation 62, 63 et 64. Les tranchées d'isolation 64 et 65 présentent avantageusement une même profondeur. Les zone implantées 14, 17 et 18 sont coplanaires au plan de masse 11, au canal inférieur 19, et à la zone 13.

Le transistor 2 ainsi formé est ainsi un transistor à effet de champ de type pMOS dont la grille est formée par le drain du transistor 1.

La figure 7 est une vue en coupe transversale d'une variante du circuit de la figure 2. Dans cette variante, une reprise d'épitaxie peut être effectuée sur les zone implantées 14, 17 et 18, pour éviter la différence d'altitude avec la couche active 15. Dans cet exemple, les zone implantées 14 et 18 s'étendent plus profondément que la couche 92, et plus profondément que les tranchées d'isolation 62 et 63.

Les transistors de protection sous-jacents illustrés précédemment sont du type à effet de champ. Cependant, en utilisant une zone 19 de dimension et de dopage appropriés, on peut réaliser la protection sous-jacente sous forme de transistor bipolaire afin d'utiliser le phénomène de «snapback » pour évacuer la décharge électrostatique. Le collecteur du transistor bipolaire est alors formé par la zone implantée 18 et par le plan de masse 11, l'émetteur du transistor bipolaire est formé par la zone implantée 14 et par la zone 13, et la base de ce transistor est formée par le caisson 12, connecté au potentiel E3 par l'intermédiaire de la zone implantée 17.

## Revendications

1. Circuit intégré (9), **caractérisé en ce qu'il** comprend :
- un premier transistor à effet de champ (1) ;
- une couche isolante enterrée (92) de type UTBOX, formée à l'aplomb dudit premier transistor ;
- un plan de masse (11) ménagé à l'aplomb de la grille et du canal du premier transistor sous la couche isolante enterrée (92), le plan de masse présentant un premier type de dopage ;
- un premier élément semiconducteur (13) ménagé sous la couche isolante enterrée (92), le premier élément semiconducteur présentant le premier type de dopage ;
- un deuxième élément semiconducteur (19) ménagé sous la couche isolante enterrée (92) et décalé latéralement par rapport à la grille du premier transistor, le deuxième élément semiconducteur étant en contact avec et séparant le plan de masse et le premier élément semiconducteur, le deuxième élément semiconducteur présentant un deuxième type de dopage opposé au premier, les premiers et deuxième éléments semi-conducteurs étant ménagés à l'aplomb de la source ou du drain du premier transistor ;
- des première et deuxième électrodes (18, 14) de polarisation en contact respectivement avec le plan de masse (11) et avec le premier élément semi-conducteur (13), la première électrode présentant le premier type de dopage et étant connectée à une première tension de polarisation (E1), la deuxième électrode présentant le premier type de dopage et étant connectée à une deuxième tension de polarisation (E2) différente de la première tension;
- un caisson semi-conducteur (12) présentant le deuxième type de dopage et ménagé à l'aplomb du premier plan de masse et des premier et deuxième éléments semi-conducteurs;
- une première tranchée d'isolation (65) isolant le premier transistor (1) d'autres composants électroniques du circuit intégré, la première tranchée s'étendant au travers de la couche isolante enterrée jusque dans le caisson (12) ;
- des deuxième et troisième tranchées d'isolation (62,63) isolant le premier transistor (1) respectivement des première et deuxième électrodes (18,14), et s'étendant jusqu'à une profondeur strictement inférieure à l'interface entre le plan de masse et le caisson.

2. Circuit intégré selon la revendication 1, dans lequel la deuxième électrode est connectée électriquement au drain ou à la source à l'aplomb duquel les premier et deuxième éléments semi-conducteurs sont ménagés, et dans lequel la première électrode est connectée électriquement à l'autre parmi le drain et la source du premier transistor.

3. Circuit intégré selon la revendication 2, dans lequel la première électrode est connectée électriquement à la source du premier transistor, dans lequel la deuxième électrode est connectée électriquement au drain du premier transistor.

4. Circuit intégré selon l'une quelconque des revendications précédentes, comprenant :
- une troisième électrode (17) en contact avec le caisson (12) ;
- une quatrième tranchée d'isolation (64) isolant la troisième électrode par rapport aux première et deuxième électrodes et s'étendant au travers de la couche isolante enterrée (92) jusque dans le caisson (12).

5. Circuit intégré selon la revendication 4, dans lequel la troisième électrode est polarisée à un potentiel de masse.

6. Circuit intégré selon l'une quelconque des revendications précédentes, dans lequel ledit premier transistor est un transistor de type FDSOI.

7. Circuit intégré selon l'une quelconque des revendications précédentes, dans lequel le premier type de dopage est de type n.

8. Circuit intégré selon l'une quelconque des revendications 1 à 7, dans lequel le premier type de dopage est de type p.

9. Circuit intégré selon l'une quelconque des revendications précédentes, dans lequel le premier transistor est de type nMOS.

10. Circuit intégré selon l'une quelconque des revendications précédentes, dans lequel le plan de masse et les premier et deuxième éléments semi-conducteurs sont inclus dans un transistor à effet de champ dont la grille est formée par le drain ou la source à l'aplomb duquel les premier et deuxième éléments semiconducteurs sont formés.

11. Circuit intégré selon l'une quelconque des revendications précédentes, dans lequel lesdites première et deuxième électrodes (18,14) incluent chacune une zone implantée semi-conductrice présentant une concentration de dopants au moins 50 fois supérieure à la concentration de dopants dans le caisson (12).

12. Circuit intégré selon l'une quelconque des revendications précédentes, dans lequel les concentrations de dopants des premier et deuxième éléments semi-conducteurs et du plan de masse sont identiques.

13. Circuit intégré selon l'une quelconque des revendications précédentes, dans lequel la partie supérieure des première et deuxième électrodes est affleurante à la partie supérieure de la deuxième tranchée d'isolation (62).
